# EUROPEAN PATENT APPLICATION

(11) **EP 4 819 203 A1**
(43) Date of publication of application: **07.10.2026**
(21) Application number: 24897699.5
(22) Date of filing: 29.11.2024
(51) Int. Cl.: H01L 23/427, F28D 15/02, H05K 1/02

(54) **HEAT DISSIPATION SUBSTRATE, VAPOR CHAMBER, AND FUNCTIONAL MODULE**

(30) Priority: 29.11.2023 JP 2023201676
(71) Applicant: Kyocera Corporation, Kyoto-shi, Kyoto 612-8501 (JP)
(72) Inventor: KONISHI, Yoshitada, Kyoto-shi, Kyoto 612-8501 (JP)
(74) Representative: Viering, Jentschura & Partner mbB Patent- und Rechtsanwälte
(86) International application number: PCT/JP2024/042344
(87) International publication number: WO 2025/116017

(57) **Abstract**

A heat dissipation substrate includes a base body. The base body includes a first plate including a mounting region for a heat source, a second plate located in a Z direction with respect to the first plate, an internal space located between the first plate and the second plate, and a supporting column located in the internal space and providing a connection between the first plate and the second plate along the Z direction. The supporting column includes a first portion in which a cross-sectional area perpendicular to the Z direction partially increases in a range including a position of connection to the first plate. The mounting region, in a planar see-through view, overlaps with at least a part of a widened portion which is included in the first portion and in which the cross-sectional area of the supporting column increases.

## Description

### TECHNICAL FIELD

The present disclosure relates to a heat dissipation substrate, a vapor chamber, and a functional module.

### BACKGROUND OF INVENTION

There exists a vapor chamber that efficiently dissipates heat by a heat transfer medium moving at high speed in a liquid-phase state and a gas-phase state. Japanese Unexamined Patent Application Publication No. 2017-044356 discloses a shape in which supporting columns are located in such a way as to avoid a mounting position of an electronic component that is the target of heat dissipation in order to reduce deformation of a base body while preventing hindrance of heat dissipation.

### SUMMARY

One aspect of the present disclosure is:
[1] A heat dissipation substrate comprising:
   a base body including
      a first plate including a mounting region for a heat source;
      a second plate located in a first direction with respect to the first plate;
      an internal space located between the first plate and the second plate; and
      a supporting column located in the internal space and providing a connection between the first plate and the second plate along the first direction, wherein
   the supporting column includes a first portion in which a cross-sectional area perpendicular to the first direction partially increases in a range including a position of connection to the first plate, and
   the mounting region, in a planar see-through view, overlaps with at least a part of a widened portion which is included in the first portion and in which the cross-sectional area of the supporting column increases.
[2] The heat dissipation substrate according to [1], wherein
   an increase rate of the cross-sectional area in the first portion is non-linear in relation to a positional change in the first direction.
[3] The heat dissipation substrate according to [2], wherein
   a surface shape of the first portion is an arc shape in a view of a cross section along the first direction.
[4] The heat dissipation substrate according to [1] or [2], wherein
   the supporting column is non-uniform in terms of cross-sectional increased width in a planar see-through view, and
   the mounting region, in the planar see-through view, overlaps with a part, of the widened portion, where the increased width is small.
[5] The heat dissipation substrate according to [1] or [2], wherein
   the supporting column is non-uniform in terms of cross-sectional increased width in a planar see-through view, and
   the mounting region, in the planar see-through view, overlaps with a part, of the widened portion, where the increased width is large.
[6] The heat dissipation substrate according to [1] or [2], wherein
   the supporting column includes a second portion in which the cross-sectional area partially increases in a range including a part connected to the second plate.
[7] The heat dissipation substrate according to [6], wherein
   a cross-sectional increased width of the second portion is smaller than a cross-sectional increased width of the first portion.
[8] The heat dissipation substrate according to any one of [1] to [7], comprising:
   a wick located in the internal space.
[9] A vapor chamber comprising:
   the heat dissipation substrate according to [8]; and
   a heat transfer medium located in the internal space.
[10] A functional module comprising:
   a functional component that generates heat; and
   the vapor chamber according to [9] on which the functional component is mounted.

### BRIEF DESCRIPTION OF THE DRAWINGS

FIG. 1A is a horizontal cross-sectional view of a vapor chamber including a heat dissipation substrate.
FIG. 1B is a vertical cross-sectional view of the vapor chamber.
FIG. 2 is a view illustrating a cross section of a wick.
FIG. 3 is an enlarged view illustrating a cross section of the wick.
FIG. 4 is a cross-sectional view illustrating a range from a first plate to a second plate of a hollow portion.
FIG. 5A is an enlarged view of a part of one powder particle that is a constituent of the wick.
FIG. 5B is a view illustrating a cross section along the line B1-B1 in FIG. 5A.
FIG. 6A is a cross-sectional view for explaining a shape of a supporting column of the present embodiment and a positional relationship of a heat source therewith.
FIG. 6B is a cross-sectional view for explaining a shape of a supporting column of the present embodiment and a positional relationship of a heat source therewith.
FIG. 6C is a cross-sectional view for explaining a shape of a supporting column of the present embodiment and a positional relationship of heat sources therewith.
FIG. 7A is a schematic view illustrating an example of a positional relationship between a supporting column and a range in a planar see-through manner.
FIG. 7B is a schematic view illustrating an example of a positional relationship between a supporting column and ranges in a planar see-through manner.
FIG. 7C is a schematic view illustrating an example of a positional relationship between a supporting column and a range in a planar see-through manner.
FIG. 7D is a schematic view illustrating an example of a positional relationship between a supporting column and ranges in a planar see-through manner.
FIG. 8A is a schematic view illustrating an example of, in a case where a heat source is supported by a plurality of supporting columns, a positional relationship between the heat source and the supporting columns in a planar see-through manner.
FIG. 8B is a schematic view illustrating an example of, in a case where a heat source is supported by a plurality of supporting columns, a positional relationship between the heat source and the supporting columns in a planar see-through manner.
FIG. 8C is a schematic view illustrating an example of, in a case where a heat source is supported by a plurality of supporting columns, a positional relationship between the heat source and the supporting columns in a planar see-through manner.
FIG. 9A is a cross-sectional view illustrating another example of a widened portion.
FIG. 9B is a cross-sectional view illustrating another example of the widened portion.
FIG. 10A is a view illustrating another example of the widened portion.
FIG. 10B is a view illustrating another example of the widened portion.
FIG. 11A is a cross-sectional view for explaining a positional relationship between a widened portion and powder particles according to a radius of curvature.
FIG. 11B is a cross-sectional view for explaining a positional relationship between a widened portion and powder particles according to a radius of curvature.
FIG. 12A is a schematic view illustrating another example of the shape of the widened portion in a planar see-through manner.
FIG. 12B is a schematic view illustrating another example of the shape of the widened portion in a planar see-through manner.
FIG. 13A is a view illustrating another example of the widened portion.
FIG. 13B is a view illustrating another example of the widened portion.
FIG. 13C is a view illustrating another example of the widened portion.
FIG. 14A is a view illustrating another example of the widened portion.
FIG. 14B is a view illustrating another example of the widened portion.
FIG. 15 is a view illustrating another example of a cross section of the supporting column in the vapor chamber.
FIG. 16A is a view illustrating a functional module according to Embodiment 2 of the present disclosure.
FIG. 16B is a view illustrating a functional module according to Embodiment 3 of the present disclosure.
FIG. 17A is a view illustrating a functional module according to Embodiment 4 of the present disclosure.
FIG. 17B is a view illustrating a functional module according to Embodiment 5 of the present disclosure.
FIG. 17C is a view illustrating a functional module according to Embodiment 6 of the present disclosure.

### DESCRIPTION OF EMBODIMENTS

Based on the drawings, embodiments will be described below.

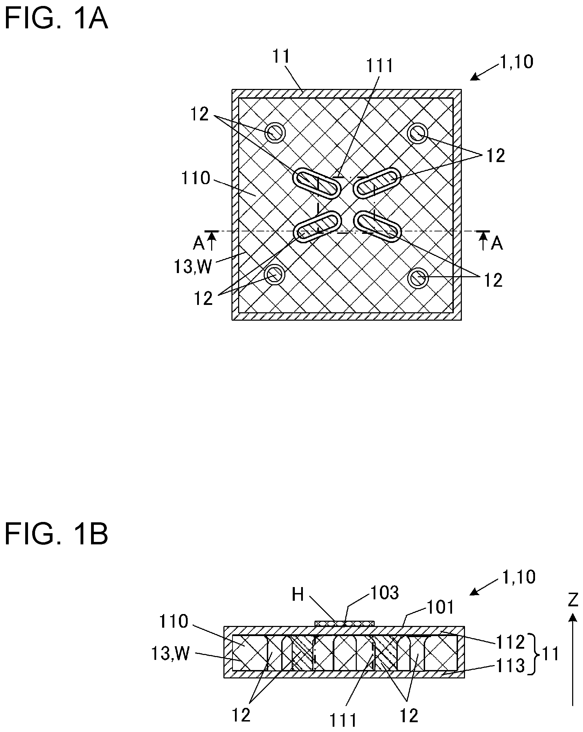

FIG. 1A is a horizontal cross-sectional view of a vapor chamber 1 including a heat dissipation substrate 10 of the present embodiment. FIG. 1B is a vertical cross-sectional view of the vapor chamber 1. The horizontal cross-sectional view of FIG. 1A is a cross-sectional view taken along a plane that passes through the center in the Z direction, meaning a height direction, and is parallel to a first surface 101. The Z direction represents a first direction in the present embodiment. The vertical cross-sectional view of FIG. 1B is a cross-sectional view taken along a section line AA in FIG. 1A.

The heat dissipation substrate 10 of the vapor chamber 1 includes a base body 11 including an internal space 110. The base body 11 may have a rectangular parallelepiped shape. Alternatively, the outer edge of the base body 11 may be chamfered at each side, corner, or the like. Supporting columns 12 and a wick 13 are located in the internal space 110. For example, the center lies within a corresponding range 111 that overlaps, in a planar see-through view, with a mounting region 103 where an electronic component or the like, as a heat source that is the target of heat dissipation, is mounted. The shape of the corresponding range 111 does not have to be a square in a plan view. The shape, in a plan view, of the corresponding range 111 may be various shapes conforming to the shape of the component that is the heat source.

The base body 11 hermetically seals the internal space 110. The base body 11 is made of a thermally conductive material and may contain, for example, a metal such as copper or aluminum. Alternatively, the base body 11 may be a ceramic or a mixture of ceramic and metal.

The base body 11 includes a first plate 112 located on a side where the mounting region 103 lies, i.e., on a +Z side, and a second plate 113 located on a -Z side that is opposite to the side where the mounting region 103 lies. On the outer surface of the first plate 112, in addition to the electronic component as the heat source being mounted on the mounting region 103, wiring, connection pads, and the like for connection to the electronic component may be located. Sidewalls surrounding the internal space 110 are connected to the peripheral portion of the first plate 112 and the peripheral portion of the second plate 113.

The supporting columns 12 extend within the internal space 110 in a direction perpendicular to the first surface 101 including the mounting region 103 in a planar see-through view. The supporting columns 12 may include a supporting column that is substantially rectangular in a horizontal cross-section, with four corners rounded. Alternatively, instead of the rectangle with rounded corners, the supporting columns 12 may include a supporting column having a shape in which two semicircles are connected by a rectangle therebetween. The supporting column 12 may be a member integral with the first plate 112 and different from the second plate 113. The second plate 113 may be joined to other portions including the first plate 112, the supporting columns 12, and the sidewalls with a brazing material or the like. The number of the supporting columns 12 illustrated in FIG. 1A is reduced for the sake of description, and the actual number of them may be greater than the illustrated number.

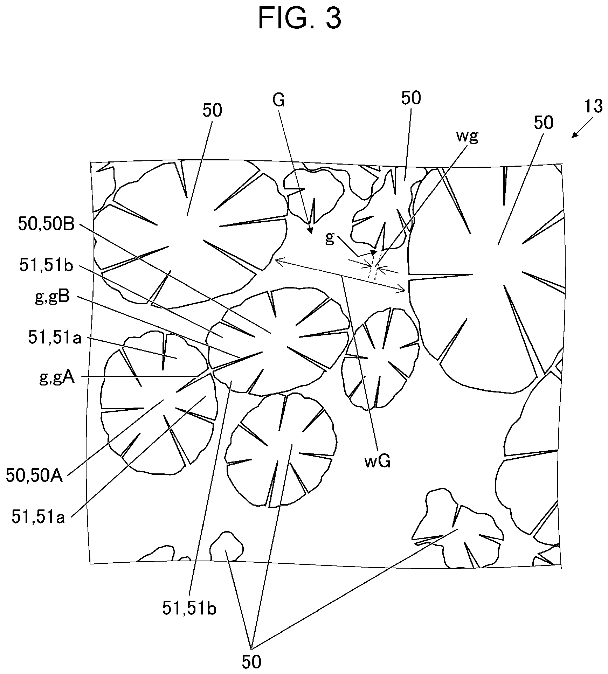

The wick 13 is located at a portion within the internal space 110 where the supporting columns 12 are not present. The wick 13 may be, for example, a porous body in which powder containing a plurality of particles is bonded and which includes voids between the particles. In the description hereinafter, each particle of the powder is referred to as a powder particle. The voids in this case are at least partially connected, and a heat transfer medium W in a liquid phase or a gas phase can flow through them. Each of the plurality of powder particles may be spherical, or may have any other shape or a non-uniform shape. The term "spherical" is not limited to a strict true sphere or an oblate sphere, but is a concept encompassing a sphere including distortions or small irregularities. The surface of a powder particle 50 may include fine protrusions 51 (see FIG. 3). Such powder particles 50 may be formed by, for example, an atomization method. Another part of the powder particle 50 may have another shape, for example, a structure protruding in a certain direction. Alternatively, the wick 13 may be a mesh member in which linear members are woven into a mesh shape, or may have a structure in which a plurality of membranes with a large number of holes are laminated at intervals. The wick may have a stand-alone structure or a multiple-combined structure, and may be a metal, a ceramic, or a combination thereof.

The wick 13 may have a structure in which the entirety of the plurality of powder particles 50 is fixed by bonding parts of adjacent powder particles 50 to each other. The component of each powder particle 50 may be a metal such as copper. Bonding between adjacent powder particles 50 may be realized by a sintering process to an extent that densification of the plurality of powder particles 50 does not progress. The particle size of the powder particle 50 may be 1 µm to 1000 µm, 10 µm to 700 µm, or 20 µm to 500 µm. The particle size of the powder particle 50 may be 20 µm, 100 µm, or 200 µm. The particle size means an average of a major diameter and a minor diameter. The particle size means a median particle size in a particle size distribution.

The wick 13 may be fixed to the internal space 110 in such a way as to be in contact with the first plate 112. The wick 13 may be fixed to the internal space 110 in such a way as to be in contact with inner side surfaces of the base body 11 and side surfaces of the supporting columns 12. The fixation may be realized through bonding, to the first plate 112 and the side surfaces, of some of the powder particles 50 in contact therewith. The bonding may be realized by a sintering process to an extent that densification of the plurality of powder particles 50 does not progress.

The bonding between the powder particles 50 in the wick 13 and the bonding between the first plate 112 and the powder particles 50 may be realized by the same sintering process.

### <Details 1 of Voids G>

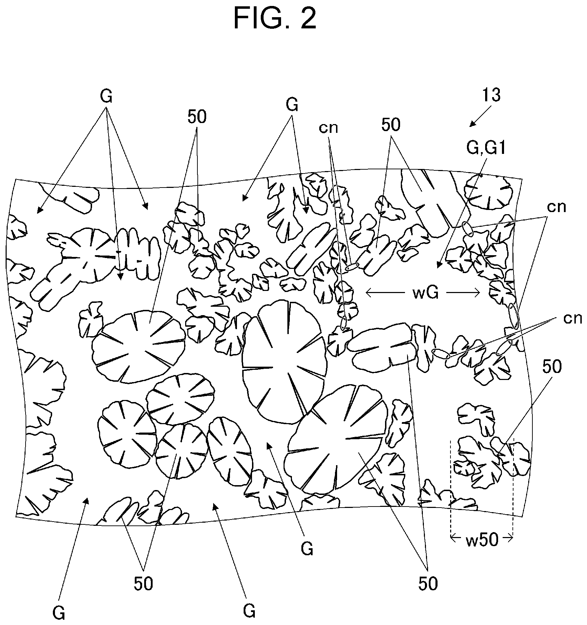

FIG. 2 is a view illustrating a cross section of the wick 13. In the wick 13, a plurality of powder particles 50 are located with voids G. In FIG. 2, cross-sectional hatching of the powder particles 50 is omitted. The plurality of voids G included in the wick 13 may include a first void G1 having a width wG larger than an average particle size w50 of the powder particles 50 in the cross section. The cross section mentioned above may be a cross section in an arbitrary direction.

In a cross-sectional photograph, the void G is easily identifiable because its contrast is significantly different from that of the powder particle 50. Therefore, the size and cross-sectional shape of the void G can be observed from the cross-sectional photograph. Almost all of the voids G are connected in a three-dimensional space. However, by dividing the voids G into blocks for each mass in the cross-sectional photograph, the entirely connected voids G can be regarded as an aggregate of a plurality of voids G. Individual voids G in the cross section are defined as follows. That is, first, in a linearly continuous void region, a maximum width in a direction orthogonal to the linear direction is determined. Next, a location that is connected to the void region and narrowed to a width of 1/5 or less of the maximum width is defined as a periphery of one void G. By such a definition, a range including the void region having the maximum width and surrounded by the powder particles 50 and the periphery can be identified as one void G. Then, the width of each void G can be determined.

By observing the surface of the wick 13 using an SEM (Scanning Electron Microscope), individual powder particles 50 can be easily identified. Then, the particle size of each powder particle 50 can be determined from the surface observation. The particle size is an average of a major diameter and a minor diameter. By selecting a plurality of dispersed regions and collecting statistics of the particle sizes of the powder particles 50 in each region, an average particle size of the plurality of powder particles 50 constituting the wick 13 is determined.

The above configuration improves the ease of movement of the heat transfer medium W in a liquid phase or a gas phase via the first void G1 because it includes the first void G1 having the width wG larger than the average particle size w50 of the powder particles 50. Therefore, such a wick 13 contributes to good heat dissipation characteristics of the vapor chamber 1 by the heat transfer medium W functioning as a refrigerant.

### <Details 2 of Voids G>

As illustrated in FIG. 2, in the cross section of the wick 13, there may be four or more connection points cn between the first void G1 and other voids G. The number of the connection points cn may be five or more, or may be six or more. When boundaries of the individual voids G and the first void G1 are determined by the above definition, the first void G1 in FIG. 2 is connected to other adjacent voids G via six connection points cn.

This configuration further improves the ease of movement of the heat transfer medium W in a liquid phase or a gas phase via the first void G1 because the first void G1 that is large is connected to other voids G at four or more connection points cn in the cross section. By having more connection points cn, the ease of movement of the heat transfer medium W is further improved. Therefore, it contributes to good heat dissipation characteristics of the vapor chamber 1.

### <Details of Gap g of Powder Particle 50>

FIG. 3 is an enlarged view illustrating a cross section of the wick 13. In FIG. 3, cross-sectional hatching of the powder particles 50 is omitted. Each powder particle 50 of the wick 13 includes gaps g between fine protrusions 51. In the cross section of the wick 13, the width wg of the gap g of the powder particle 50 may be smaller than the width wG of the void G connected to this gap g. According to this configuration, the wick 13 includes voids G of various sizes and gaps g each having a width wg even smaller than the width of the void G, thereby improving a holding force of the heat transfer medium W by a capillary force of the gaps g while improving the ease of movement of the heat transfer medium W by the voids G. Therefore, the occurrence of local drying of the wick 13 is reduced, and phase transition of the heat transfer medium W and exchange between the heat transfer medium W in a liquid phase and the heat transfer medium W in a gas phase are smoothly performed. Consequently, it contributes to good heat dissipation characteristics of the vapor chamber 1.

The plurality of powder particles 50 may include a first particle 50A and a second particle 50B adjacent to each other, and a gap gA of the first particle 50A and a gap gB of the second particle 50B may adjoin each other. That is, the protrusions 51a and 51a of the first particle 50A with the gap gA interposed therebetween and the protrusions 51b and 51b of the second particle 50B with the gap gB interposed therebetween are bonded by a sintering process, resulting in a structure in which the gaps gA and gB adjoin each other. Because of this configuration, the fine gaps gA and gB are formed to be continuously long, making it possible to hold more heat transfer medium W in the gaps g. Therefore, the occurrence of local drying of the wick 13 is further reduced, contributing to good heat dissipation characteristics of the vapor chamber 1.

The direction in which the gap gA of the first particle 50A widens and the direction in which the gap gB of the second particle 50B widens may intersect with each other. That is, the gaps gA and gB may adjoin each other such that a virtual plane expanding along the gap gA of the first particle 50A and a virtual plane expanding along the gap gB of the second particle 50B intersect with each other. According to such a configuration, a narrow void G between the first particle 50A and the second particle 50B communicates with the gaps gA and gB, and a strong capillary force can be generated at this part.

### <Entire Structure of Wick>

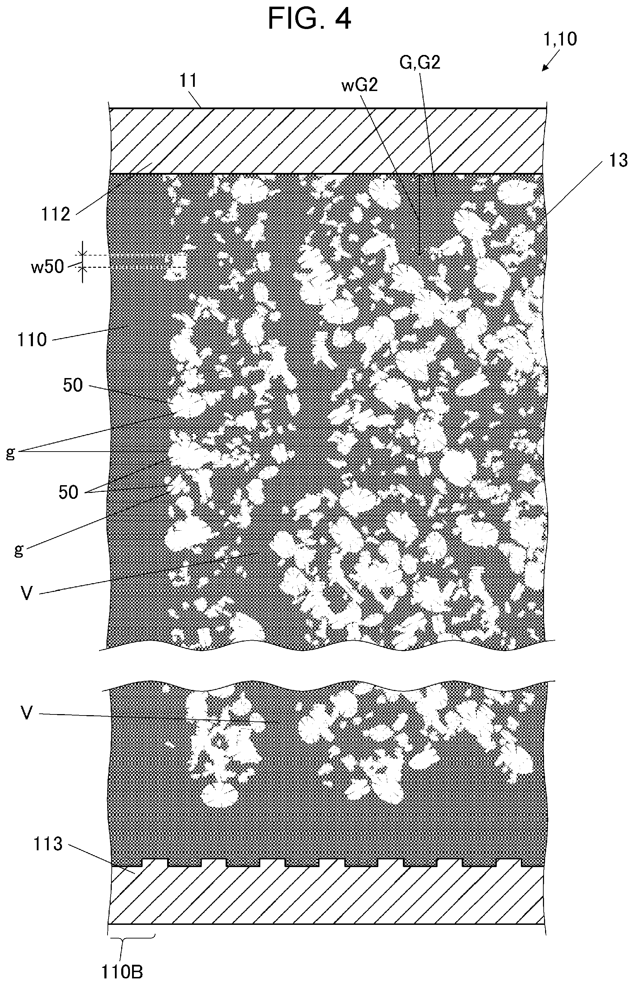

FIG. 4 is a cross-sectional view illustrating a range from the first plate 112 to the second plate 113 in the internal space 110. In FIG. 4, a cross section of the powder particles 50 is shown in white, and the voids G are shown by shading.

The wick 13 may include a communication passage V communicating from the first plate 112 to an end that is opposite to the first plate 112 via the voids G in this cross-sectional view. With this configuration, the heat transfer medium W in a gas phase can be smoothly transferred from the first plate 112 side of the wick 13 to the opposite side through the communication passage V. In addition, the wick 13 can smoothly transfer the heat transfer medium W in a liquid phase from the side opposite to the first plate 112 of the wick 13 toward the first plate 112 by the capillary action of the small voids G located around the communication passage V or the gaps g of the powder particles 50. Therefore, heat is smoothly transferred by phase transition of the heat transfer medium W, contributing to good heat dissipation characteristics of the vapor chamber 1.

In the cross section of the wick 13, the plurality of voids G may include a second void G2 that is in contact with the first plate 112 and has a width wG2 larger than the average particle size w50 of the powder particles 50 in a direction normal to an inner surface of the first plate 112. This configuration increases an amount of the heat transfer medium W in a liquid phase flowing back toward the first plate 112. Therefore, it is possible to increase an amount of phase transition of the heat transfer medium W at the first plate 112 and to increase an amount of heat absorption via the first plate 112.

The gap g of the powder particle 50 may adjoin a region 110B where the wick 13 is not located. That is, when the region 110B is regarded as a flow path of the heat transfer medium W in a gas phase, the gap g of the powder particle 50 may adjoin the flow path. If a liquid-phase transfer path adjoins the flow path of the heat transfer medium W in a gas phase, local drying of the liquid-phase transfer path is likely to occur at this location. On the other hand, if walls more than necessary are provided to separate the two from each other, the internal space 110 becomes narrower. In the present embodiment, since the fine gap g that generates a strong capillary force adjoins the flow path of the heat transfer medium W in a gas phase, the occurrence of the local drying mentioned above can be reduced. Therefore, with this wick 13, a flow of the heat transfer medium W in a gas phase and a return flow of the heat transfer medium W in a liquid phase going against the flow are smoothly performed, contributing to good heat dissipation characteristics of the vapor chamber 1.

### <Details of Powder Particle>

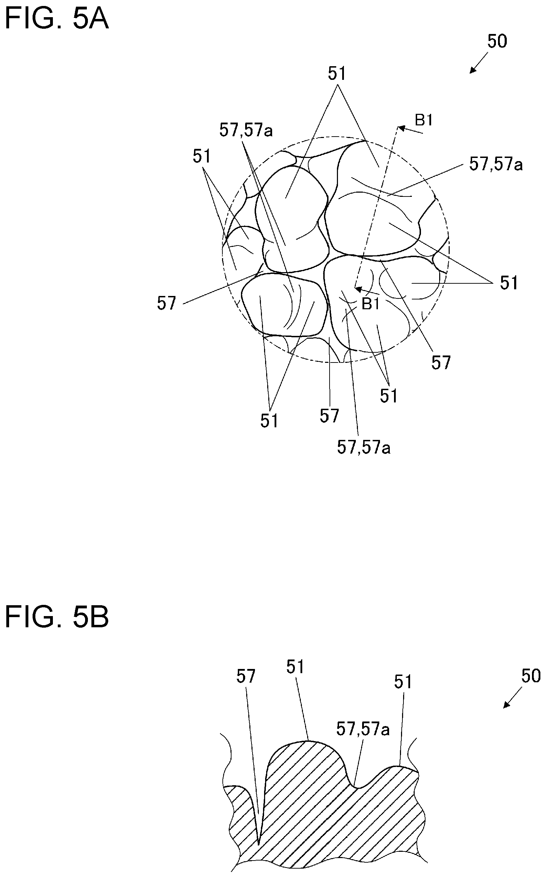

FIG. 5A is an enlarged view of a part of one powder particle that is a constituent of a wick. FIG. 5B is a view illustrating a cross section along the line B1-B1 in FIG. 5A. The powder particle 50 may exhibit increased smoothness in its outer shape in comparison with the powder in its raw form. Specifically, among the plurality of powder particles 50 constituting the wick 13, each of those having protrusions 51 may include a plurality of valleys 57 located between the plurality of protrusions 51 respectively, and 20% or more of the plurality of valleys 57 exposed on the surface may be gentle valleys 57a each having a rounded bottom. The gentle valley 57a is a valley portion having a rounded bottom like a U-shaped groove as illustrated in FIG. 5B. The ratio of occupation by the gentle valleys 57a among the plurality of valleys 57 exposed on the surface may be 50% or more, or may be 80% or more.

It is difficult to count the ratio of the gentle valleys 57a for all of the powder particles 50 of the wick 13. The ratio of the gentle valleys 57a may be calculated by randomly selecting a plurality of regions from a photograph obtained by an SEM and counting the valleys 57 and the gentle valleys 57a in the regions.

The gentle valley 57a can be generated by controlling a temperature and a time of sintering in a sintering process for fixing the plurality of powder particles 50 in the internal space 110.

The gentle valley 57a exerts an effect of enhancing the ease of movement of the heat transfer medium W in a liquid phase. Since the gentle valleys 57a are included in the above ratio among the valleys 57 in the surface, the capability of transporting the heat transfer medium W held in the wick 13 is enhanced, and better heat dissipation characteristics of the vapor chamber 1 can be obtained.

The vapor chamber 1 includes the heat transfer medium W in the internal space 110. That is, the heat transfer medium W is located in the voids of the wick 13. The heat transfer medium W is a fluid that undergoes phase transition between a gas and a liquid. The heat transfer medium W only needs to be a fluid at a normal temperature and have a boiling point at which it evaporates into a gas upon receiving heat from a heat source. The heat transfer medium W is, for example, water. Alternatively, the heat transfer medium W may be any other material such as acetone, methanol, or ammonia.

The heat transfer medium W vaporizes due to heat transmitted from a heat source H near the mounting region 103, i.e., mainly on the +Z side of the corresponding range 111, and leaves the vicinity of the mounting region 103. The heat transfer medium W having vaporized dissipates heat to the second plate 113 on the -Z side and thus liquefies. The heat transfer medium W having liquefied flows through the gaps of the wick 13 by capillary action and returns to the vicinity of the mounting region 103. This circulating flow of the heat transfer medium W is faster than heat conduction by metal or the like, absorbs the heat generated by the heat source H from the first plate 112 side, and quickly dissipates the heat to the second plate 113 side. When this is performed, the region where the gas moves away from the corresponding range 111 and the region where the liquid moves toward the corresponding range 111 are separated within the wick 13.

In the present embodiment, the wick 13 is located in the entire internal space 110; however, instead, there may be a region without the wick 13. Such a region behaves as a region where the heat transfer medium W having vaporized selectively flows. For example, as illustrated in FIG. 1A, four supporting columns 12 may extend radially in four directions from the corresponding range 111. The wick 13 may be located in two spaces among spaces between these four supporting columns 12 so that a liquid flows in toward the corresponding range 111, and two spaces may be without the wick 13 so that a gas flows out toward the outside of the corresponding range 111.

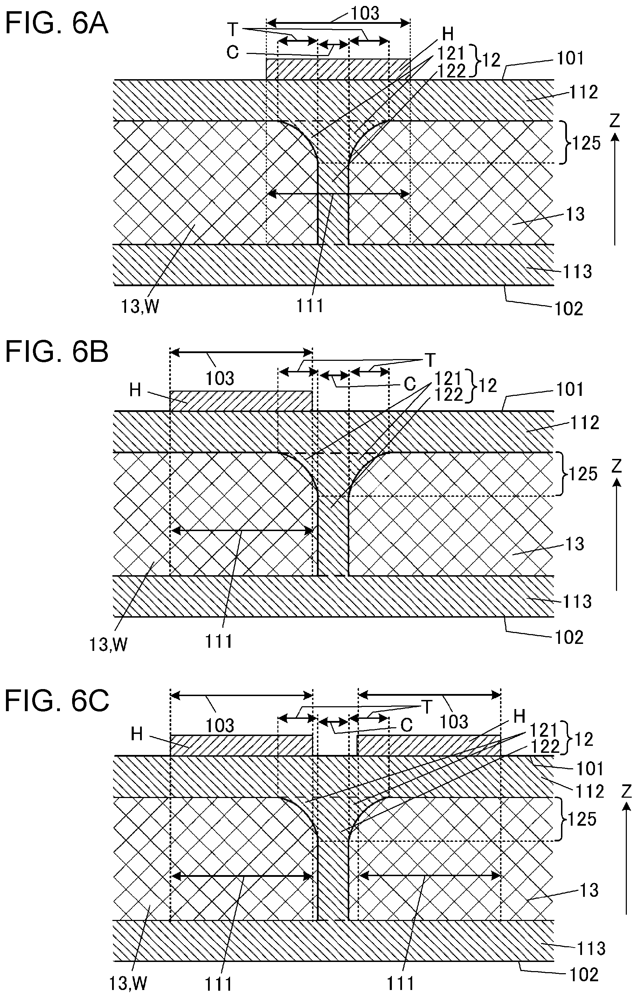

FIGs. 6A to 6C are cross-sectional views for explaining a shape of the supporting column 12 of the present embodiment and a positional relationship of the heat source(s) H therewith. These cross-sectional views show a cross section along the Z direction passing through the center of any one of the supporting columns 12.

As illustrated in FIG. 6A, the supporting column 12 has a beam-like structure in which the cross-sectional area perpendicular to the Z direction partially increases in a range including the position of connection to the first plate 112. In the description hereinafter, a range, in a planar see-through view, of the supporting column 12 at a portion where its cross-sectional area does not increase is referred to as a center portion 122. The range, in a planar see-through view, of the beam-like structure of the supporting column 12 in which its cross-sectional area increases is referred to as a widened portion 121. The widened portion 121 outside the center portion 122 in a planar see-through view partially surrounds it at its part in the Z direction. The widened portion 121, and the part of the center portion 122 surrounded by the widened portion 121, constitute a first portion 125 forming the beam-like structure. By the first portion 125, strength against a force applied to the first surface 101 is improved even if the entirety of the supporting column 12 is not thick.

The surface shape of a side surface of the first portion 125 may have a curved shape as viewed in a cross section passing through the center of the supporting column 12. The curve may be oriented in a direction in which an increase rate of the cross-sectional area of the first portion 125 increases in the +Z direction. That is, the increase rate of the cross-sectional area may be non-linear with respect to a positional change in the Z direction. In particular, the curve may have an arc shape with a predetermined radius of curvature r. When the wick 13 is obtained through powder bonding, this makes it easier for each powder particle to come into contact with and be joined to a recessed portion of the widened portion 121 more widely. Therefore, the vapor chamber 1 using the heat dissipation substrate 10 including the widened portion 121 offers improved heat transfer efficiency.

The heat source H and the mounting region 103 where the heat source H is mounted are located in such a way as to include a portion having a width C overlapping with the center portion 122 and a portion having an increased width T overlapping with the widened portion 121 in a planar see-through view. The increased width T represents a distance by which the side-surface position of the supporting column 12 as viewed in the cross section passing through the center of the supporting column 12 spreads outward from the outer edge of the center portion 122. Since the corresponding range 111 of the mounting region 103 overlaps with the widened portion 121, heat transmitted from the heat source H to the widened portion 121, which is thin in the +Z direction and has a large surface area, is quickly transmitted to the heat transfer medium W in the wick 13 and dissipated. That is, in the present embodiment, both improvement in strength of the vapor chamber 1 and improvement in heat dissipation efficiency are achieved.

As illustrated in FIG. 6B, the corresponding range 111 may be located in such a way as to overlap with the widened portion 121 but not to overlap with the center portion 122. With this positional relationship, the heat of the heat source H is more quickly transmitted to the heat transfer medium W, while the heat source H can be stably supported by the widened portion 121.

As illustrated in FIG. 6C, corresponding ranges 111 respectively corresponding to a plurality of heat sources H may overlap with the widened portion 121. That is, the heat dissipation substrate 10 may be used in a shared manner for the plurality of heat sources H.

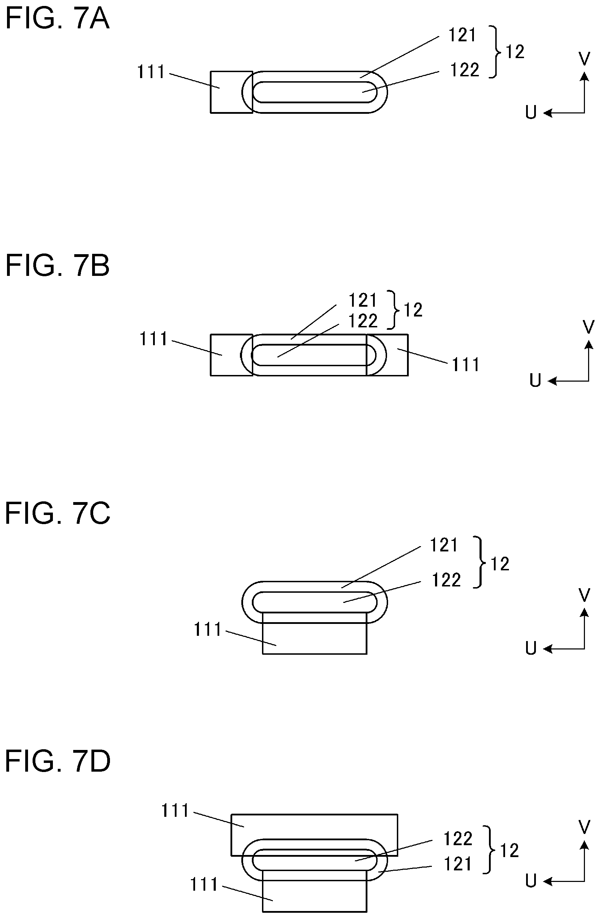

FIGs. 7A to 7D are schematic views illustrating examples of a positional relationship between the supporting column 12 and the corresponding range(s) 111 in a planar see-through manner. A U-axis direction based on a direction along a major axis of the supporting column 12 and a V-axis direction perpendicular to the U-axis direction are defined.

As illustrated in FIG. 7A, the corresponding range 111 may overlap with a part, of the widened portion 121, located at a long-side end of the supporting column 12. When the corresponding range 111 is not too large in the U-axis direction and the V-axis direction in comparison with the short-side length and the increased width T of the supporting column 12, the heat source H can be stably supported in such a positional relationship. The width in the present disclosure means a distance to the center portion 122 at each point of the widened portion 121.

As illustrated in FIG. 7B, a plurality of corresponding ranges 111 may respectively overlap with the widened portion 121 at both long-side ends of the supporting column 12. One or both of the plurality of corresponding ranges 111 may overlap with the center portion 122. Even with such a positional relationship, both efficiency of heat dissipation from the heat source H and more stable support of the heat source H are achieved.

As illustrated in FIG. 7C, the corresponding range 111 may overlap with the widened portion 121 along a long side of the supporting column 12. This makes it possible to set a long range of supporting by the widened portion 121 in the corresponding range 111. Therefore, when the width of the heat source H is long, etc., the heat source H is more stably supported by the widened portion 121.

As illustrated in FIG. 7D, a plurality of corresponding ranges 111 may respectively overlap with the widened portion 121 on both sides along long sides of the supporting column 12. The length of one or both of the corresponding ranges 111 may be greater than the long-side length of the supporting column 12. One or both of the corresponding ranges 111 may overlap with the center portion 122. Even when the corresponding range 111 is larger than the width of the supporting column 12, the heat source H is properly supported by the widened portion 121.

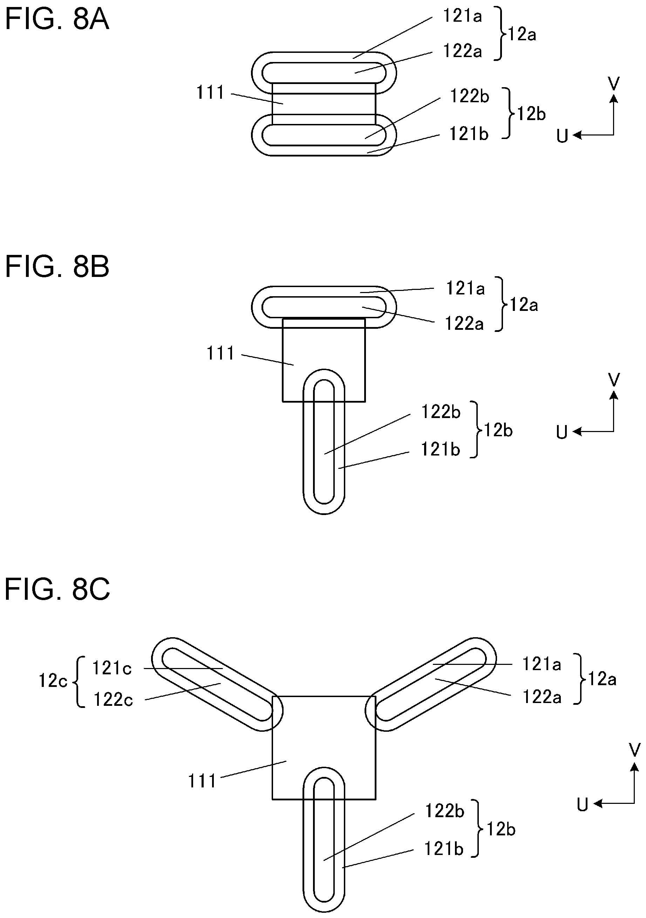

FIGs. 8A to 8C are schematic views illustrating examples of, in a case where the heat source H is supported by a plurality of supporting columns 12, a positional relationship between the heat source H and the supporting columns 12 in a planar see-through manner.

As illustrated in FIG. 8A, both ends of the corresponding range 111 may respectively overlap with the mutually facing parts of widened portions 121a and 121b of supporting columns 12a and 12b that extend in the U-axis direction and are located in parallel. Since both ends of the heat source H are supported by the widened portions 121 of the supporting columns 12, support strength improves effectively. At the same time, heat of the heat source H is efficiently transmitted to the heat transfer medium W in the wick 13 and is quickly dissipated.

As illustrated in FIG. 8B, two supporting columns 12a and 12b may be located at a right angle. The corresponding range 111 overlaps with a part along a long side of the widened portion 121a of one supporting column 12a, and overlaps with a part along an end of the widened portion 121b of a supporting column 12b different from this one. The corresponding range 111 may overlap with one or both of center portions 122a and 122b of the two supporting columns 12a and 12b.

As illustrated in FIG. 8C, three supporting columns 12a to 12c may be located radially at 120-degree intervals. The corresponding range 111 overlaps with widened portions 121a to 121c of the three supporting columns 12a to 12c, respectively. The intersection of extension lines of the three supporting columns 12a to 12c and the center of the corresponding range 111 may coincide with each other. Some or all of the center portions 122a to 122c of the three supporting columns 12a to 12c may overlap with the corresponding range 111. As described here, by increasing the number of the supporting columns 12 supporting the heat source H, heat can be efficiently transmitted from the heat source H to the heat transfer medium W while more stably supporting the periphery of the heat source H.

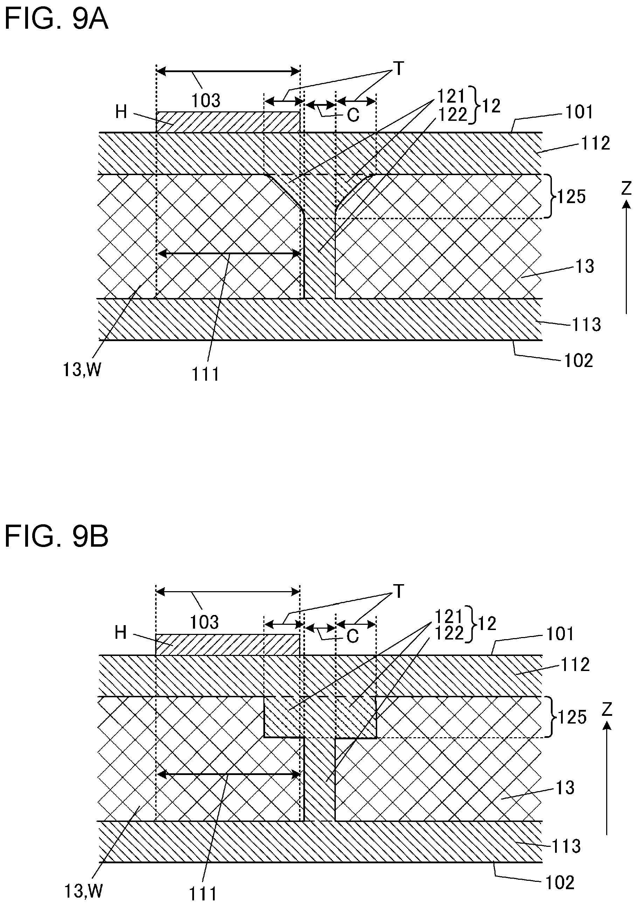

FIGs. 9A and 9B are cross-sectional views illustrating other examples of the widened portion 121. The cross-sectional position is the same as that of FIGs. 6A to 6C.

As illustrated in FIG. 9A, the widened portion 121 may have a tapered or truncated-cone side shape whose cross-sectional area increases substantially uniformly. Alternatively, as illustrated in FIG. 9B, the widened portion 121 may have a step-like structure. The step-like structure may include multiple steps. The width of the step may be about a diameter of each powder particle forming the wick 13 when the wick 13 is a bonded body of powder. By this means, each powder particle fits into the recess of the step, and heat is efficiently transmitted from the heat source H to the heat transfer medium W via the widened portion 121.

The width of the widened portion 121 in a planar see-through view does not necessarily have to be uniform around the center portion 122. That is, the widened portion 121 may be non-uniform in terms of the increased width T in a cross section. For example, the increased width T may decrease according to a distance from another supporting column 12 located nearby.

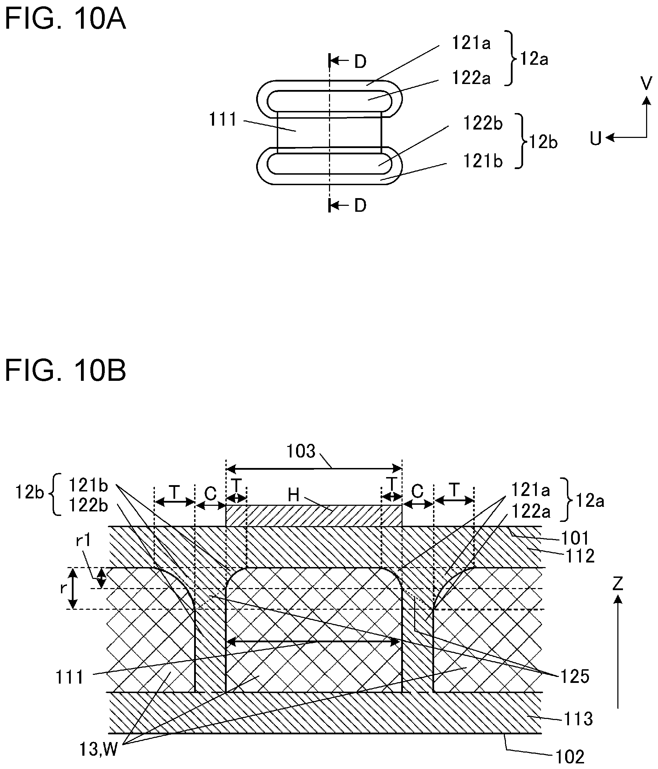

FIGs. 10A and 10B are views illustrating another example of the widened portion 121.

As illustrated in the plan view of FIG. 10A, in two parallel supporting columns 12a and 12b extending in the U-axis direction, the facing parts of the widened portions 121a and 121b may each have a narrower width than the parts of the widened portions 121a and 121b each located farther from the other supporting column. When the widened portions 121a and 121b have the curved shape of the above-described embodiment in a cross-sectional view, the curvature of the curve may be larger at a part where the increased width T is narrow, that is, may have a small radius of curvature r, such as a radius of curvature r1. Accordingly, the part where the increased width T of the cross-sectional area is small and the widened portions 121a and 121b are narrow overlaps with the mounting region 103, i.e., the corresponding range 111 in a planar see-through view. In FIG. 10A and subsequent figures, the increased width T is shown to change only according to the distance with respect to the supporting columns 12 illustrated therein; however, this does not imply any limitation. When there is another supporting column 12 in the internal space 110, the increased width T at each position of the widened portion 121 may be determined according to the distance with respect to this other supporting column 12.

FIG. 10B is a cross-sectional view taken along a section line DD in FIG. 10A. In the corresponding range 111 where the widened portions 121 on the mutually facing side of two supporting columns 12 are smaller than the widened portions 121 on the other side in terms of not only the increased width T but also the height, the volume of a space in which the wick 13 is located between the plurality of supporting columns is larger. At this time, the radius of curvature r of the outer surface of the widened portion 121 may also be reduced to the radius of curvature r1. The difference between them may be less than 1:2, such as r1:r = 3:4, 5:6, or the like. That is, r1/r ≥ 1/2 may be satisfied.

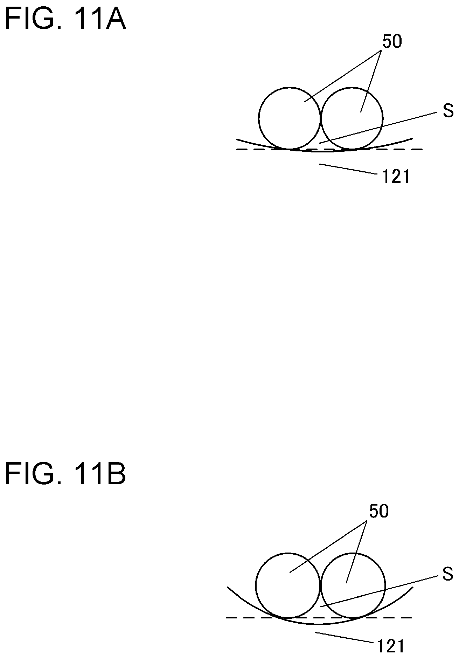

FIGs. 11A and 11B are cross-sectional views for explaining a positional relationship between the widened portion 121 and the powder particles 50 when the powder of the wick 13 is in contact with and bonded to the widened portion 121 with different radii of curvature r. The powder particles 50 are illustrated as being spherical here. For simplicity, the cross section passes through the centers of the two powder particles 50.

As illustrated in FIG. 11A, as the radius of curvature r increases, a space S between the powder particles 50 and the wall surface of the widened portion 121 becomes closer to a gap between two powder particles on a plane. On the other hand, when the radius of curvature r is small as in FIG. 11B, the volume of the space S between the powder particles 50 and the wall surface increases because the wall surface of the widened portion 121 goes deeper in a direction away from the powder particles 50. Therefore, when the radius of curvature is small and the curvature is large, the heat transfer medium W easily flows along the wall surface of the widened portion 121 with low resistance. As a result, heat release proceeds more efficiently. When the radius of the powder particle 50 is denoted as rp, r/rp may be in a range of 2 to 40, and further may be in a range of 5 to 10.

In this way, when the wick 13 has a bond structure of the powder particles 50, configuring the radius of curvature r of the widened portion 121 to be partially small makes the joining between the wall surface of the widened portion 121 and the powder easier and makes the space S between the wall surface and the powder wider as described above. Therefore, it becomes easier for the heat transfer medium W to flow through this space S with low resistance. As a result, heat dissipation efficiency in the vapor chamber 1 increases.

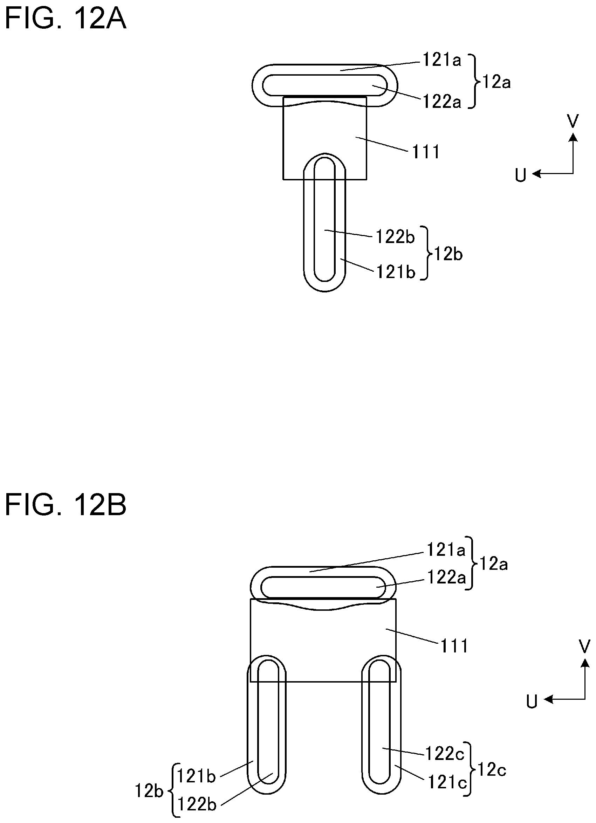

FIGs. 12A and 12B are schematic views illustrating other examples of the shape of the widened portion 121 in a planar see-through manner.

One or more supporting columns 12 may be located in orientations different from each other near one supporting column 12. For example, as illustrated in FIG. 12A, two supporting columns 12a and 12b may respectively extend in the U-axis direction and the V-axis direction and be perpendicular to each other. In this case, the supporting column 12a is closest to the supporting column 12b near the center of its one side along the major-axis direction parallel to the U-axis direction. Therefore, the widened portion 121a along the one side mentioned above may have a shape that is narrow at the center and widens toward both ends.

As illustrated in FIG. 12B, a supporting column 12a extending in the U-axis direction and two supporting columns 12b and 12c extending perpendicularly thereto in the V-axis direction may be located. The respective one ends on the +V side of the supporting columns 12b and 12c are closest to the vicinities of both ends of the supporting column 12a in the U-axis direction, which is the major-axis direction. Consequently, the supporting column 12a may have a shape in which the increased width T of the widened portion 121a is small near both ends of one side along the major-axis direction and the width increases toward the center. In FIG. 12B, since the supporting columns 12b and 12c are parallel to each other, the widened portions 121b and 121c have the increased width T smaller at their two facing sides than at their sides that are opposite to the two sides.

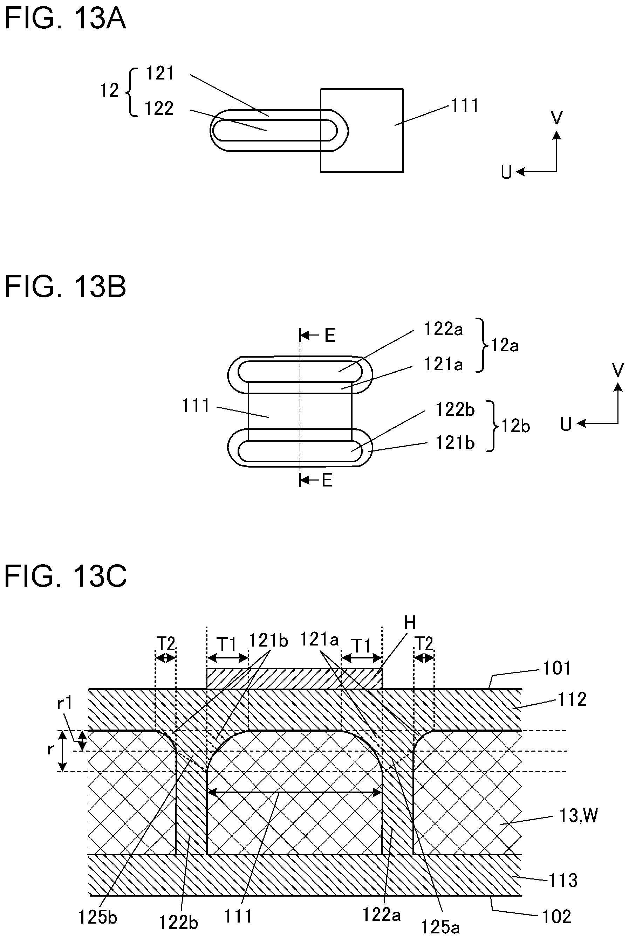

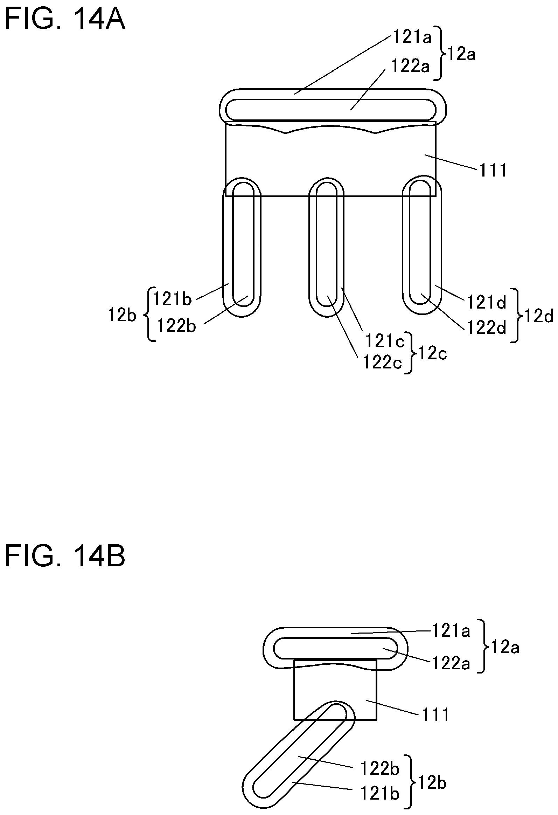

FIGs. 13A to 13C, and FIGs. 14A and 14B are views illustrating other examples of the widened portion 121.

Contrary to the above description, the widened portion 121 may have a small increased width T in the cross section at the part not overlapping with the corresponding range 111, and the width of the widened portion 121 may be narrow thereat. In other words, the part having a large increased width T in the cross section of the widened portion 121 may overlap with the corresponding range 111.

In the example of a planar see-through view illustrated in FIG. 13A, the corresponding range 111 is located in such a way as to overlap with one end of the supporting column 12. The width of the widened portion 121 may be narrow near the end that is opposite to the one end overlapping with the corresponding range 111. This makes it possible to support the heat source H more stably by the wide part of the widened portion 121. On the other hand, at the part that is not needed for the support, the range of the wick 13 is expanded by an amount corresponding to the small width of the widened portion 121, making it easier for the heat transfer medium W to flow.

In the example of a plan view illustrated in FIG. 13B, the supporting columns 12a and 12b are arranged in parallel and extend in the U-axis direction. The corresponding range 111 is located in such a way as to include the facing parts of the widened portions 121a and 121b between the supporting columns 12a and 12b. The widened portions 121a and 121b are narrow at the part not overlapping with the corresponding range 111 among the parts along the long sides of the supporting columns 12a and 12b.

FIG. 13C is a cross-sectional view taken along a section line EE in FIG. 13B.

Contrary to the example illustrated in FIG. 10B, the radius of curvature r of the outer surfaces of the widened portion 121a and the widened portion 121b in the corresponding range 111 may be larger than the radius of curvature r1 of the outer surfaces of the widened portion 121a and the widened portion 121b outside the corresponding range 111, respectively. Therefore, the proportion of an increased width T1 relative to the corresponding range 111 is larger. By this means, the heat source H is supported more stably. On the other hand, an increased width T2 outside the corresponding range 111 is smaller than the increased width T1 inside the corresponding range 111. This makes it less likely that the flow of the heat transfer medium W is hindered at the part not supporting the heat source H.

As illustrated in FIG. 12B, when the supporting columns 12b and 12c extend perpendicularly to the supporting column 12a, the widened portion 121 on the side close to the supporting columns 12b and 12c has a non-uniform width. By this means, the heat source H is supported more stably by the wide part of the widened portions 121a and 121b, and the like. On the other hand, at the part that does not support the heat source H, the width of the widened portion 121 is narrow, and the heat transfer medium W easily flows.

As illustrated in the plan view of FIG. 14A, three or more supporting columns 12b to 12d may be located in relation to the supporting column 12a. In the widened portion 121a located on the side closer to the supporting columns 12b to 12d among the long sides of the supporting column 12a, minimum width parts and maximum width parts may be alternately located according to distances to the supporting columns 12b to 12d. The supporting column 12c may be interposed between the supporting columns 12b and 12d, and the part along the long sides of the widened portion 121c may be narrow, together with the end on the side closer to the supporting column 12a.

As illustrated in the plan view of FIG. 14B, the supporting column 12b may be inclined at an arbitrary angle with respect to the supporting column 12a. The width of the widened portion 121 in this case may exhibit an asymmetrical distribution with respect to the minimum-width positions.

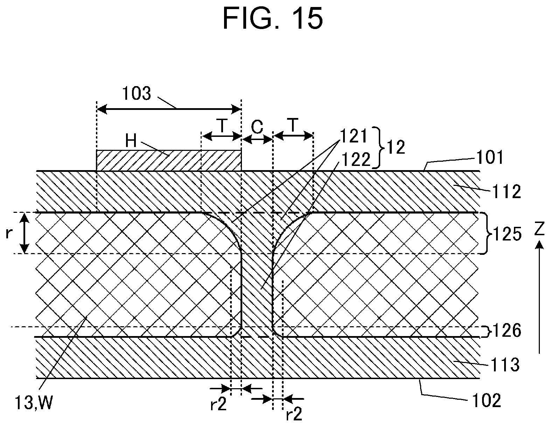

FIG. 15 is a view illustrating another example of a cross section of the supporting column 12 in the vapor chamber 1.

In addition to the widened portion 121 on the first plate 112 side, the supporting column 12 may include a widened portion 123 on the second plate 113 side. That is, the supporting column 12 includes a second portion 126 in which the cross-sectional area perpendicular to the Z direction partially increases in a range including the position of connection to the second plate 113. The widened portion 123 may have a radius of curvature r2 that is the same as the radius of curvature r of the widened portion 121. As illustrated in FIG. 15, the radius of curvature r2 of the widened portion 123 may be smaller than the radius of curvature r of the widened portion 121. That is, the increased width in the cross section of the entire widened portion 123 in the +Z direction may be smaller than the increased width in the cross section of the widened portion 121 in the +Z direction. The reduced width represents a distance from a side-surface position of the widened portion 123 to the outer edge of the center portion 122 in a cross-sectional view. Alternatively, the height of the widened portion 123 in the Z direction may be less than the height of the widened portion 121 in the Z direction.

Since the supporting column 12 includes the widened portions 121 and 123 at both ends, greater support strength can be obtained as compared with the diameter of the center portion 122 of the supporting column 12. Moreover, since the diameter of the center portion 122 suffices to be small, it is possible to increase the size of the wick 13 by an amount of this slimness. Therefore, heat transport efficiency improves, and heat release from the heat source H is performed more quickly.

In this case, the widened portion 123 of the supporting column 12 does not necessarily have to be made of the same material as the material of the supporting column 12. For example, the widened portion 123 may be a fillet or the like that is generated when the supporting column is joined by means of a brazing material or the like to a bottom plate on the side where the second surface 102 is located.

### (Functional Module)

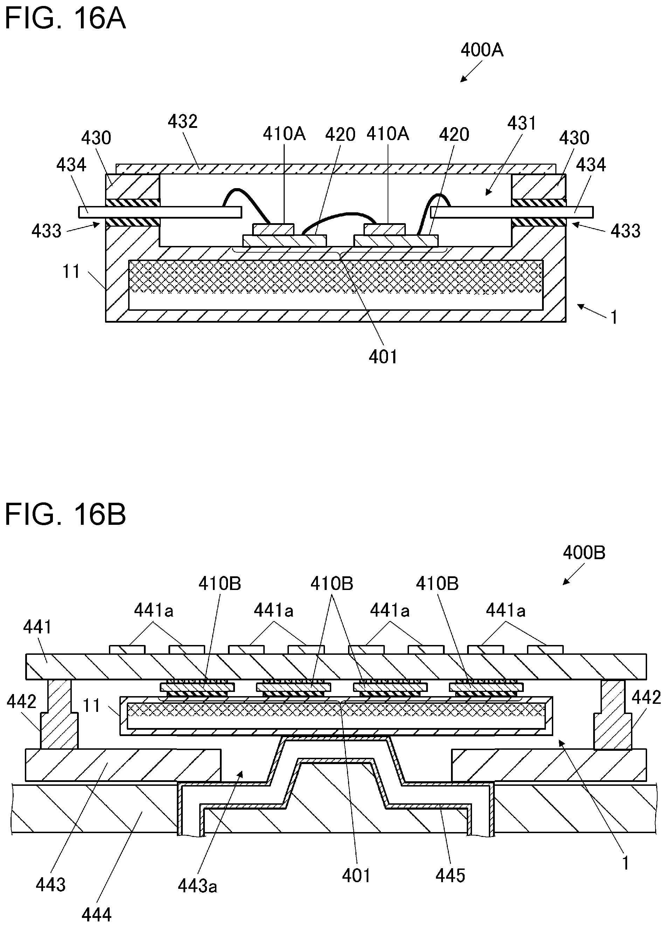

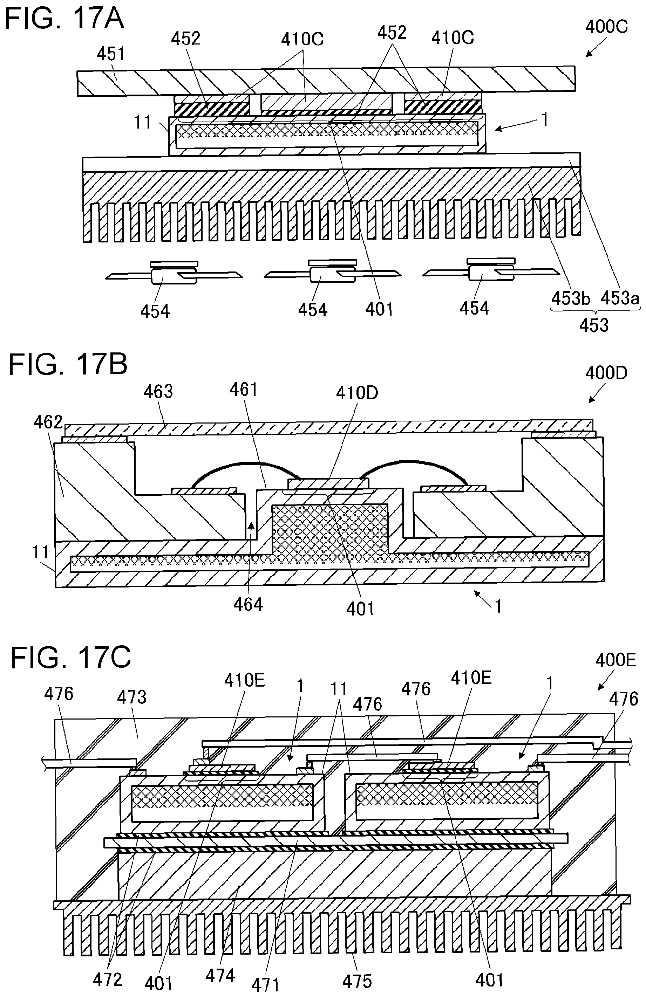

FIGs. 16A to 17C are views illustrating functional modules according to Embodiments 2 to 6 of the present disclosure, respectively. Functional modules 400A to 400E of Embodiments 2 to 6 respectively include functional components 410A to 410E as heat sources H that generate heat, and the vapor chamber 1 of Embodiment 2 on which the functional components 410A to 410E are mounted. Specific examples of the functional modules 400A to 400E will be described below; however, the following structures are presented just by way of example, and various modifications are possible for details and the like. In FIGs. 16A to 17C, detailed illustration of an internal structure of the vapor chamber 1 is omitted.

### (Functional Module of Embodiment 2)

The functional module 400A of Embodiment 2 may be a light source module, and the functional component 410A may be a light-emitting element such as an LED (Light Emitting Diode) or an LD (Laser Diode). The above-mentioned LD may have a configuration to output a laser beam for processing or a configuration to output a laser beam for illumination purposes.

The functional component 410A may be mounted on the vapor chamber 1, with a submount 420 disposed therebetween. The submount 420 is a substrate smaller than the vapor chamber 1 and may be a ceramic such as silicon nitride, silicon carbide, aluminum nitride, or aluminum oxide. A plurality of functional components 410A may be mounted on a mounting portion 401. In this case, the submount 420 may correspond to the heat source H.

The vapor chamber 1 may include a sidewall portion 430 surrounding the periphery of the mounting portion 401 of the base body 11, and the mounting portion 401 may be located on the inner bottom surface of a recess 431 surrounded by the sidewall portion 430. The opening of the recess 431 may be covered by a light-transmissive member 432 such as a lens. The light-transmissive member 432 may be joined to the sidewall portion 430, and the recess 431 may be sealed. The sidewall portion 430 may include a through-hole 433 in a horizontal direction; a conductive member 434 that transmits operating power to the functional component 410A may be located in the through-hole 433, and the through-hole 433 and the conductive member 434 may be joined in such a way as to be sealed with glass therebetween. A cooling mechanism that is not illustrated may be located under the base body 11.

According to the functional module 400A of Embodiment 2, a large amount of heat can be dissipated from the functional component 410A, which is a light-emitting element, via the vapor chamber 1. Therefore, the functional component 410A, which is a light-emitting element, can stably emit light with high luminance. Furthermore, when the functional module 400A includes a plurality of functional components 410A that are light-emitting elements, uniform heat distribution among the plurality of functional components 410A can be achieved by virtue of high heat dissipation of the vapor chamber 1, and therefore, luminance among the plurality of functional components 410A can be made uniform.

### (Functional Module of Embodiment 3)

The functional module 400B of Embodiment 3 may be a wireless module that transmits wireless signals from a wireless base station or the like. The functional component 410B may be a signal processing circuit such as a BFIC (Beam Forming Integrated Circuit) that transmits wireless signals with directivity via an array antenna. A plurality of functional components 410B may be mounted on the mounting portion 401. The functional component 410B, which is a signal processing circuit, may be connected to an antenna substrate 441 such as a PAAM (Phased Array Antenna Module) substrate on which an array antenna is mounted. That is, a plurality of functional components 410B may be mounted on the mounting portion 401, the antenna substrate 441 may be located above the plurality of functional components 410B, and a plurality of antennas 441a (for example, patch antennas) may be located on an upper part of the antenna substrate 441.

The vapor chamber 1 may be located between the antenna substrate 441 and another substrate 443 located below the antenna substrate 441 via spacers 442. A shield case 444 may be located below the substrate 443. The substrate 443 may include an opening 443a, and a heat dissipation component 445 such as a heat pipe embedded in the shield case 444 may extend to the inside and outside of the shield case 444. The heat dissipation component 445 may be in contact with the vapor chamber 1 from below via the opening 443a and guide heat from the vapor chamber 1 to the outside of the shield case 444.

According to the functional module 400B of Embodiment 3, a large amount of heat can be dissipated from the functional component 410B, which is a signal processing circuit, via the vapor chamber 1. Therefore, wireless signals can be transmitted stably. Therefore, it can contribute to increasing the power of wireless signals, i.e., increasing the output of wireless radio waves, and reducing a module volume.

### (Functional Module of Embodiment 4)

The functional module 400C of Embodiment 4 may be a computer module using an LSI (Large Scale Integration) for calculation purposes as the functional component 410C. As the functional component 410C, various LSIs may be applied, such as an LSI for AI (Artificial Intelligence) processing, an LSI for cloud processing, an LSI for display calculation, or a calculating LSI mounted in a workstation. The functional component 410C may include, in addition to the LSI mentioned above, a memory IC (Integrated Circuit) used by the LSI.

While one or more functional components 410C are mounted on a module substrate 451 such as a PCB (Printed Circuit Board), the vapor chamber 1 may be incorporated in such a way as to contact the functional component(s) 410C from the side opposite to the module substrate 451. Here, "contact" is not limited to direct contact, but is a concept including connection via a material 452 with high thermal conductivity, for example, a heat transfer sheet, heat transfer grease, or the like. In this case, the material 452 may be included in the heat source H. A heat dissipation component 453 such as a heat pipe 453a and a cooling fin 453b connected to the heat pipe 453a may be connected below the base body 11 of the vapor chamber 1. The functional module 400C may further include a cooling device 454 such as a fan for cooling the heat dissipation component 453.

According to the functional module 400C of Embodiment 4, a large amount of heat can be dissipated from the functional component 410C such as an LSI and a memory IC via the vapor chamber 1. Therefore, calculation processing by the functional component 410C can be performed stably. Therefore, it is possible to support a high calculation capability of the LSI, and the functional module 400C having the high calculation capability can be realized. Moreover, in response to an increase in heat generation due to miniaturization of wiring in the LSI, high-speed operation, and the like, and in response to an increase in heat generation due to three-dimensional mounting of the LSI and the memory IC, it is possible to dissipate heat from the functional component 410C such as the LSI and the memory IC by the vapor chamber 1.

### (Functional Module of Embodiment 5)

The functional module 400D of Embodiment 5 may be a sensor module using an image sensor as the functional component 410D. The vapor chamber 1 may include a convex portion 461 that is a partial protrusion of the base body 11, and the mounting portion 401 may be located at the top of the convex portion 461.

The functional module 400D, which is a sensor module, may include a package 462 encapsulating the functional component 410D, and a light-transmissive member 463 such as a lens. The package 462 may include an opening 464 as a part thereof, and the vapor chamber 1 and the package 462 may be joined such that the convex portion 461 is accommodated in the opening 464. Wiring for sending electrical signals and power may be built in the package 462, and electrical signals and power may be sent between the functional component 410D and the outside of the package 462 via the wiring. A cooling mechanism that is not illustrated may be located under the vapor chamber 1.

According to the functional module 400D of Embodiment 5, a large amount of heat can be dissipated from the functional component 410D, which is an image sensor, via the vapor chamber 1. Therefore, a high-function image sensor that performs high-speed information processing with a large amount of heat generation can be applied as the functional component 410D. Therefore, it can contribute to enhancing the functionality of the functional module 400D.

### (Functional Module of Embodiment 6)

The functional module 400E of Embodiment 6 may be a power module using a power semiconductor for power control as the functional component 410E. The power semiconductor may be a switching element or a diode. The functional module 400E may include a plurality of vapor chambers 1 and a plurality of functional components 410E, and the plurality of vapor chambers 1 may be mounted on one insulating plate 471. The insulating plate 471 may be a ceramic such as silicon nitride, silicon carbide, aluminum nitride, or aluminum oxide. Heat dissipation fins 475 may be attached to the lower side of the insulating plate 471, with a metal heat dissipation plate 474 disposed therebetween. The vapor chamber 1 and the heat dissipation plate 474 may be joined to the insulating plate 471 by means of a bonding material 472. An upper wall of the vapor chamber 1 may be a conductive member, a wiring member 476 may be electrically connected to the upper wall, and an electrical connection of the functional component 410E may be made such that a current flows via the wiring member 476 and the upper wall. The periphery of the vapor chamber 1, the functional component 410E, the insulating plate 471, and the heat dissipation plate 474 may be sealed with a mold material 473.

According to the functional module 400E of Embodiment 6, a large amount of heat can be dissipated from the functional component 410E, which is a power semiconductor, via the vapor chamber 1. Therefore, a high-output power semiconductor with a large amount of heat generation can be applied as the functional component 410E, and, furthermore, high integration and miniaturization of the functional module 400E can be achieved.

As described above, the heat dissipation substrate 10 of the present embodiment includes the base body 11. The base body 11 includes the first plate 112, the second plate 113, the internal space 110 located between the first plate 112 and the second plate 113, and the supporting column 12. The first plate 112 includes the mounting region 103 for the heat source H. The second plate 113 is located in the -Z direction with respect to the first plate 112. The supporting column 12 is located in the internal space 110 and provides a connection between the first plate 112 and the second plate 113 along the Z direction. The supporting column 12 includes the first portion 125 in which the cross-sectional area perpendicular to the Z direction partially increases in a range including a position of connection to the first plate 112. The mounting region 103, in a planar see-through view, overlaps with at least a part of the widened portion 121 which is included in the first portion 125 and in which the cross-sectional area of the supporting column 12 increases.

As described here, the supporting column 12 includes a beam-like structure, and the mounting region 103 is located in such a way as to overlap with the widened portion 121 owing to the beam-like structure in a planar see-through view; therefore, the heat dissipation substrate 10 can stably support the heat source H while reducing distortion of the heat dissipation substrate 10. On the other hand, since it is not necessary for the entirety of the supporting column 12 to have a cross-sectional area that is about the same as the beam-like structure, a space to be occupied by the wick 13 can be expanded. Therefore, by using the heat dissipation substrate 10, heat dissipation is performed more effectively.

The increase rate of the cross-sectional area in the first portion 125 may be non-linear in relation to a positional change in the Z direction. This makes it easier to obtain the widened portion 121. Moreover, when the wick 13 is formed by bonding the plurality of powder particles 50, the powder particles 50 and the wall surface of the widened portion 121 are easily joined, resulting in more efficient heat transfer.

The surface shape of the first portion 125 may have a predetermined radius of curvature r in a view of a cross section along the Z direction. By virtue of such a uniform concave shape, the powder particles 50 and the wall surface of the widened portion 121 are easily joined on average, resulting in more efficient heat transfer.

The supporting column 12 may be non-uniform in terms of cross-sectional increased width in a planar see-through view. The mounting region 103 in this case may overlap, in the planar see-through view, with a part where the cross-sectional increased width is small in the supporting column 12. This makes it possible to, while supporting the heat source H by the beam-like structure, expand an area occupied by the wick 13 directly below it. Therefore, the heat dissipation substrate 10 achieves both reduction of deformation and heat dissipation performance.

Alternatively, the mounting region 103 may overlap, in the planar see-through view, with a part where the cross-sectional increased width is large in the supporting column 12. By this means, the heat dissipation substrate 10 can more stably support the heat source H by the widened portion 121. Therefore, the heat dissipation substrate 10 can further reduce deformation.

The supporting column 12 may include the second portion 126 in which the cross-sectional area perpendicular to the Z direction partially increases in a range including a part connected to the second plate 113. Having a beam-like structure also on the side of the part joined to the second plate 113 makes it possible to make the supporting column 12 more stable and reduce the distortion of the base body 11 according to a force applied to the first surface 101.

The cross-sectional reduced width of the second portion 126 may be smaller than the cross-sectional increased width of the first portion 125. By having a larger beam-like structure on the side of the first plate 112 having the first surface 101 receiving a direct external force, reduction of distortion of the base body 11 and maintenance of heat dissipation performance can be achieved more appropriately.

The heat dissipation substrate 10 may include the wick 13 located in the internal space. Since the wick 13 can cause the heat transfer medium W that is in the form of a liquid to flow quickly, the heat dissipation substrate 10 is suitably usable for a vapor chamber.

The vapor chamber 1 of the present embodiment includes the heat dissipation substrate 10 mentioned above and the heat transfer medium W located in the internal space 110. According to the vapor chamber 1, both reduction of deformation of the base body 11 and heat dissipation efficiency can be achieved.

The functional modules 400A to 400E of the present embodiment include the functional components 410A to 410E that generate heat, and the vapor chamber 1 mentioned above on which the functional components 410A to 410E are mounted. According to the functional modules 400A to 400E, it is possible to quickly release heat generated by the functional components 410A to 410E. Therefore, the functional modules 400A to 400E can be provided with the functional components 410A to 410E with a large amount of heat generation, thus achieving high functionality of the functional modules 400A to 400E.

Note that the foregoing embodiments show just examples, and various changes are possible.

For example, the wall surfaces of the first portion 125 and the second portion 126 may have a more complex or irregular shape than the examples having been disclosed above. The radii of curvature r, r1, and r2 when these wall surfaces have an arc shape in a cross-sectional view may be average values. The curvature of the wall surface may change halfway.

Although examples in which all of the supporting columns 12 have a beam-like structure have been described above, this does not imply any limitation. Some of the supporting columns 12 may lack a beam-like structure. The supporting columns 12 lacking a beam-like structure may lack an overlap with the corresponding range 111. Some of the supporting columns 12 overlapping with the corresponding range 111 may lack a beam-like structure.

The beam-like structure does not have to surround the entire periphery around the center portion 122 of the supporting column 12. The beam-like structure may be provided only on a part of the periphery around the center portion 122.

The increased width of the second portion 126 may also be non-uniform. A part or the whole of the increased width of the second portion 126 does not have to be smaller than the increased width of the first portion 125.

Although examples in which the wick 13 is located throughout its entirety in the Z direction have been described above, this does not imply any limitation. The wick 13 may have a gap in an intermediate part between the first plate 112 and the second plate 113 in the +Z direction as long as it is in contact with the first plate 112 and the second plate 113 and further as long as a part in contact with the first plate 112 and a part in contact with the second plate 113 are continuous.

Although a relationship between the wick 13 in which the plurality of powder particles 50 are bonded and the wall-surface shape of the widened portion 121 has been described above, also in a case where the wick 13 has a mesh structure, the shape of the wick 13 may conform to the wall-surface shape of the widened portion 121.

The contents of the foregoing disclosure may be arbitrarily divided or combined as long as they do not conflict with each other.

Specific contents such as the structure, configuration, material, and size shown in the foregoing embodiments can be appropriately changed without departing from the spirit of the present disclosure. The scope of the present invention encompasses the scope of the invention recited in the claims and the scope of its equivalents.

### INDUSTRIAL APPLICABILITY

The present disclosure can be utilized for a heat dissipation substrate and a vapor chamber.

### REFERENCE SIGNS

1 vapor chamber
10 heat dissipation substrate
103 mounting region
11 base body
110 internal space
111 corresponding range
12, 12a to 12d supporting column
13 wick
121, 121a to 121c, 123 widened portion
122, 122a to 122c center portion
400A to 400E functional module
401 mounting portion
410A to 410E functional component
420 submount
430 sidewall portion
431 recess
432 light-transmissive member
433 through-hole
434 conductive member
441 antenna substrate
441a antenna
442 spacer
443 substrate
443a opening
444 shield case
445 heat dissipation component
451 module substrate
452 material
453 heat dissipation component
453a heat pipe
453b cooling fin
454 cooling device
461 convex portion
462 package
463 light-transmissive member
464 opening
471 insulating plate
472 bonding material
473 mold material
474 heat dissipation plate
475 heat dissipation fin
476 wiring member
50 powder particle
50A first particle
50B second particle
G void
g, gA, gB gap
H heat source
S space
V communication passage
W heat transfer medium

## Claims

1. A heat dissipation substrate comprising:
a base body including
a first plate including a mounting region for a heat source;
a second plate located in a first direction with respect to the first plate;
an internal space located between the first plate and the second plate; and
a supporting column located in the internal space and providing a connection between the first plate and the second plate along the first direction, wherein
the supporting column includes a first portion in which a cross-sectional area perpendicular to the first direction partially increases in a range including a position of connection to the first plate, and
the mounting region, in a planar see-through view, overlaps with at least a part of a widened portion which is included in the first portion and in which the cross-sectional area of the supporting column increases.

2. The heat dissipation substrate according to claim 1, wherein
an increase rate of the cross-sectional area in the first portion is non-linear in relation to a positional change in the first direction.

3. The heat dissipation substrate according to claim 2, wherein
a surface shape of the first portion is an arc shape in a view of a cross section along the first direction.

4. The heat dissipation substrate according to claim 1 or 2, wherein
the supporting column is non-uniform in terms of cross-sectional increased width in a planar see-through view, and
the mounting region, in the planar see-through view, overlaps with a part, of the widened portion, where the increased width is small.

5. The heat dissipation substrate according to claim 1 or 2, wherein
the supporting column is non-uniform in terms of cross-sectional increased width in a planar see-through view, and
the mounting region, in the planar see-through view, overlaps with a part, of the widened portion, where the increased width is large.

6. The heat dissipation substrate according to claim 1 or 2, wherein
the supporting column includes a second portion in which the cross-sectional area partially increases in a range including a part connected to the second plate.

7. The heat dissipation substrate according to claim 6, wherein
a cross-sectional increased width of the second portion is smaller than a cross-sectional increased width of the first portion.

8. The heat dissipation substrate according to any one of claims 1 to 7, comprising:
a wick located in the internal space.

9. A vapor chamber comprising:
the heat dissipation substrate according to claim 8; and
a heat transfer medium located in the internal space.

10. A functional module comprising:
a functional component that generates heat; and
the vapor chamber according to claim 9 on which the functional component is mounted.
